# EUROPÄISCHE PATENTANMELDUNG

(11) **EP 1 107 039 A2**
(43) Veröffentlichungstag der Anmeldung: **13.06.2001**
(21) Anmeldenummer: 00125454.9
(22) Anmeldetag: 21.11.2000
(51) Int. Cl.: G02B 27/00, G03F 7/20, G02B 7/182

(54) **System zur Kompensation von Richtungs- und Positionsschwankungen eines von einem Laser erzeugten Lichtes**

(30) Priorität: 10.12.1999 DE 19959742
(71) Anmelder: Carl Zeiss, 89518 Heidenheim (Brenz) (DE)
(72) Erfinder: Dieckmann, Nils, 73434 Aalen (DE)
(74) Vertreter: Lorenz, Werner

(57) **Zusammenfassung**

Bei einem System zur wenigstens weitgehenden Kompensation von Richtungs- und Positionsschwankungen eines von einem Laser (1) erzeugten Lichtstrahles (2), insbesondere für mikrolithografische Beleuchtungseinrichtungen, sind ein im Laserstrahl (2) angeordneter Strahlteiler (4) und wenigstens zwei Strahlumlenkeinrichtungen (7), vorgesehen. Durch den Strahlteiler (4) wird ein Teilstrahl (2a) direkt auf eine Beleuchtungsreferenzfläche (3) der Beleuchtungseinrichtung geleitet, während ein weiterer Teilstrahl (2b) über eine Umwegleitung (5), in dem sich die wenigstens zwei Strahlumlenkeinrichtungen (6,7) befinden, zum Strahlteiler (4) zurückgeführt und anschließend ebenfalls der Beleuchtungsreferenzfläche zugeführt.

## Beschreibung

Die Erfindung betrifft ein System zur wenigstens weitgehenden Kompensation von Richtungs- und Positionsschwankungen eines von einem Laser erzeugten Lichtes, insbesondere für mikrolithografische Beleuchtungseinrichtungen. Die Erfindung betrifft auch eine Vorrichtung hierzu.

Die Beeinflussung und Veränderung eines von einem Laser erzeugten Lichtes, insbesondere bezüglich Drehung und Fokusierung ist allgemein bekannt. Hierzu wird z.B. auf die EP 293823 B1 und die US-PS 4,703,166 verwiesen. Beide Patentschriften befassen sich mit einer aktiven Fokussensoreinrichtung, wobei durch Abstimmen der Wellenlänge eines Laserstrahles herausgefunden werden soll, wie groß der Abstand des Objektives zu einem Wafer ist. Hierzu erfolgt eine aktive Regelung durch eine entsprechende Drehung von Spiegeln. Gleichzeitig sollen dabei auch Vibrationsbewegungen eines Positionstisches kompensiert werden.

Laserbetriebene Beleuchtungssysteme, wie sie z.B. in mikrolithografischen Projektionsbelichtungsanlagen verwendet werden, reagieren empfindlich auf Positions- und Richtungsschwankungen der Laserstrahlung am Eingang des Systems. Insbesondere die Gleichförmigkeit der Lichtverteilung und der Schwerpunktstrahlwinkelverlauf (Telezentrie) werden dadurch negativ beeinflußt. Positions- und Richtungsschwankungen lassen sich auch bei Einhaltung von möglichst kleinen Toleranzen nicht immer vermeiden. So treten z.B. Änderungen alleine schon dann ein, wenn sich im Betrieb der Laser erwärmt.

Der vorliegenden Erfindung liegt daher die Aufgabe zugrunde, Positions- und Richtungsschwankungen eines von einem Laser erzeugten Lichtes, insbesondere für mikrolithografische Beleuchtungseinrichtungen, durch die die Gleichförmigkeit der Lichtverteilung und der Verlauf des Schwerpunktstrahlwinkels negativ beeinflußt werden, soweit wie möglich zu kompensieren.

Erfindungsgemäß wird diese Aufgabe durch die in Anspruch 1 genannten Merkmale systemmäßig gelöst.

Eine Vorrichtung hierzu ist in Anspruch 3 aufgezeigt.

Erfindungsgemäß erfolgt nun eine Aufteilung des von einem Laser erzeugten Laserstrahles zwischen dem Laser und dem Beleuchtungssystem bzw. der Beleuchtungseinrichtung an einem Strahlteiler in zwei Teilstrahlen, wobei ein erster Teilstrahl direkt auf eine Beleuchtungsreferenzfläche geleitet wird. Der zweite Teilstrahl wird über eine Umwegleitung mit wenigstens zwei Strahlumlenkeinrichtungen geleitet bevor er nach einem erneuten Durchgang des Strahlteilers anschließend ebenfalls der Beleuchtungsreferenzfläche zugeführt wird.

Durch die erfindungsgemäße Maßnahme ist es möglich, Schwankungen des Lasers bezüglich seiner Position zu symmetrisieren und damit deren Wirkung auf das Beleuchtungssystem zu eliminieren.

Gleichzeitig läßt sich mit dem erfindungsgemäßen System und der Vorrichtung hierzu auch eine Kompensation von Richtungsschwankungen des Lasers erreichen. Zwar kommt es dabei zu einem leichten Strahlenversatz, aber in der Praxis beträgt der Strahlenversatz weniger als 1% der Strahlenbreite. Wesentlich ist, daß durch das vorgeschlagene System eine Stabilisierung der Schwerpunktstrahlposition und der Schwerpunktstrahlrichtung erreicht wird.

Da es durch den Strahlteiler zu mehreren Umläufen des über die Strahlumlenkeinrichtung geführten Teilstrahles kommt, kann für eine gleichmäßigere Lichtverteilung in vorteilhafter Weise vorgesehen sein, daß die Aufteilung des Laserstrahles in einem Teilungsverhältnis von erstem Teilstrahl zu zweitem Teilstrahl mit 33.3/66.7 steht.

Als Strahlteiler läßt sich vorteilhafterweise ein Strahlteilerwürfel verwenden, weil auf diese Weise ein Strahlversatz, der durch eine Strahlteilerplatte selbst erzeugt werden würde, vermieden wird. Selbstverständlich ist der Strahlteilerwürfel auf die verwendete Wellenlänge abzustimmen.

In einfacher Weise lassen sich als Strahlumlenkeinrichtungen Umlenkspiegel verwenden.

Nachfolgend ist ein Ausführungsbeispiel anhand der Zeichnung prinzipmäßig beschrieben.

Es zeigt:
- Figur 1: den Verlauf eines von einem Laser erzeugten Laserstrahles mit Kompensation von Richtungsschwankungen,
- Figur 2: den Verlauf eines von einem Laser erzeugten Laserstrahles mit Kompensation von Positionsschwankungen.

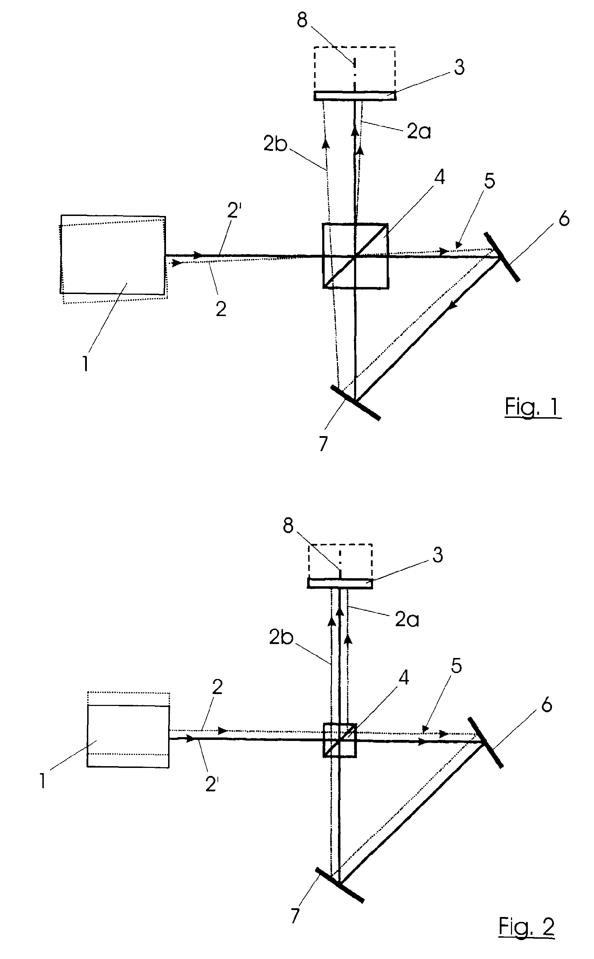

Von einem nicht näher dargestellten Laser 1 wird ein Laserstrahl 2 erzeugt. Der Laserstrahl 2 ist als optimaler Strahl 2' in den Figuren 1 und 2 als durchgezogener Strich dargestellt, wobei keinerlei Richtungs- und Positionsschwankungen vorhanden sind. In punktierter Darstellung ist in beiden Figuren ein dejustierter Strahl 2 dargestellt. Der optimale Strahl 2' läßt sich in der Praxis in dieser exakten Form nicht realisieren. Entsprechend den Abweichungen tritt bei einer Dejustage des Strahles 2 bei Richtungsschwankungen des Lasers (siehe Fig. 1), d.h. bei einer Schrägstellung des Lasers, ein Winkelfehler an einer Beleuchtungsreferenzfläche 3 auf. Die Beleuchtungsreferenzfläche 3 befindet sich bei bekannten Systemen und Vorrichtungen im allgemeinen im direkten Laserstrahl. Je größer der Abstand des Lasers 1 von der Beleuchtungsreferenzfläche 3 ist, um so stärker wirkt sich die Winkelabweichung aus.

Bei einem Parallelversatz des Lasers 1 (Fig. 2) tritt in gleicher Weise ein Parallelversatz des Laserstrahles 2 auf, der ebenfalls zu einer Verschiebung des Laserstrahles 2 aus der Symmetrieebene führt.

In Fig. 1 ist nun die Kompensation von Richtungsschwankungen des Lasers 1 dargestellt. Hierzu befindet sich im Strahlengang zwischen dem Laser 1 und der Beleuchtungseinrichtung bzw. der Beleuchtungsreferenzfläche 3 ein Strahlteiler 4. An dem Strahlteiler 4 erfolgt eine Aufteilung des auf ihn treffenden Laserstrahles 2 in einen ersten Teilstrahl 2a, der direkt auf die Beleuchtungsreferenzfläche 3 geleitet wird, und in einen weiteren bzw. zweiten Teilstrahl 2b, der derart über eine Umwegleitung 5, in der sich wenigstens zwei Strahlumlenkeinrichtungen 6 und 7 befinden, geführt wird, daß der umgelenkte Teilstrahl 2b ein weiteres Mal dem Strahlteiler 4 zugeleitet wird, von wo aus er anschließend ebenfalls der Beleuchtungsreferenzfläche 3 zugeführt wird.

Da im allgemeinen der weitere Teilstrahl 2b mehrfach den Weg über die Umwegleitung 5 nimmt, wird man einen Strahlteiler, der z.B. ein Strahlteilerwürfel 4 sein kann, derart ausbilden, daß das Teilungsverhältnis vom ersten Teilstrahl, welcher direkt der Beleuchtungsreferenzfläche 3 zugeleitet wird, und dem zweiten Teilstrahl 2b, welcher den Weg über die Umwegleitung 5 mehrfach nimmt, 33.3/66.7 beträgt.

Wie aus der Fig. 1 ersichtlich ist, beeinflußt der Strahlteiler 4 den optimalen Strahl 2' in keiner Weise, denn auch der Teilstrahl, welcher den Weg über die Umwegleitung und die beiden als Umlenkspiegel 6 und 7 ausgebildeten Strahlumlenkeinrichtungen nimmt, trifft exakt in der Symmetrieebene 8 auf die Beleuchtungsreferenzfläche 3.

Der Verlauf eines dejustierten Laserstrahles 2 sieht jedoch in diesem Fall anders aus. Bei dem dargestellten Ausführungsbeispiel mit der beispielsweise vorgegebenen Winkelabweichung liegt der dem von dem Strahlteiler 4 abgelenkte Teilstrahl 2a vor, leicht rechts neben der Symmetrieebene 8 der Beleuchtungsreferenzfläche 3. Der Teilstrahl 2b, der den Weg über die Umwegleitung 5 genommen hat, trifft entsprechend links von der Symmetrieebene 8 auf die Beleuchtungsreferenzfläche 3. Dies bedeutet, er liegt im Vergleich mit dem Teilstrahl 2a jeweils auf der anderen Seite der Symmetrieebene 8. Wie ersichtlich, ergibt sich dadurch eine Strahlverbreiterung und ein minimaler Strahlversatz, aber diese Änderungen sind in der Praxis so gering, daß sie vernachlässigbar sind. Aus Übersichtlichkeitsgründen sind in den Figuren 1 und 2 die Abweichungen des Laserstrahls 2 von dem optimalen Laserstrahl 2' auch stark übertrieben dargestellt. In der Praxis treten Richtungsschwankungen auf, die kleiner als 0.2 mrad sind. Parallelverschiebungen, die nachfolgend anhand der Fig. 2 besprochen werden, liegen in einer maximalen Größenordnung von 0,5 mm, was bei Strahldurchmesser von im allgemeinen 30 mm ebenfalls vernachlässigbar ist.

Wesentlich ist lediglich, daß sich die Schwerpunktrichtung nicht ändert. Der Schwerpunktstrahl soll möglichst rechtwinklig auf die Beleuchtungsrefernzfläche 3 treffen. Dadurch, daß nun der Teilstrahl 2a rechts und der Teilstrahl 2b links von der Symmetrieebene 8 liegt, womit entsprechende Abweichungen des Schwerpunktstrahles vorhanden sind, wird jedoch erreicht, daß der Mittelwert des etwas breiter gewordenen Schwerpunktstrahles jedoch wieder senkrecht auf der Beleuchtungsreferenzfläche 3 liegt. Auf diese Weise werden die Richtungsschwankungen praktisch kompensiert. Hierzu ist es lediglich erforderlich, das Teilungsverhältnis derart geschickt zu wählen, daß beide Teilstrahlen gleich stark sind, womit dann der eine Teilstrahl mit dem anderen Teilstrahl genau kompensiert wird. Der dabei auftretende leichte Versatz spielt - wie bereits erwähnt - in der Praxis keine Rolle. Gleiches gilt auch für die geringfügig größer werdenden Divergenzen des Strahles.

Noch klarer liegen die Verhältnisse bei einer Kompensation von Postitionsschwankung des Lasers, wie es in der Fig. 2 dargestellt ist. Wie ersichtlich, liegen dabei die beiden Teilstrahlen 2a und 2b symmetrisch zur Symmetrieebene 8. In diesem Falle treffen beide Teilstrahlen rechtwinklig auf die Beleuchtungsreferenzfläche und auch die Symmetrie bleibt erhalten. Lediglich die Breite des Strahles ist geringfügig größer geworden, was jedoch - wie bereits erwähnt - in der Praxis im Vergleich zu dem Stahldurchmesser des Laserstrahles von 30 bis 40 mm vernachlässigbar ist.

## Patentansprüche

1. System zur wenigstens weitgehenden Kompensation von Richtungs- und Positionsschwankungen eines von einem Laser erzeugten Lichtstrahles, insbesondere für eine lithografische Beleuchtungseinrichtung, gekennzeichnet durch einen im Laserstrahl angeordneten Strahlteiler (4) und wenigstens zwei Strahlumlenkeinrichtungen (6,7), wobei durch den Strahlteiler (4) ein Teilstrahl (2a) direkt auf eine Beleuchtungsreferenzfläche (3) der Beleuchtungseinrichtung geleitet wird, während ein weiterer Teilstrahl (2b) über eine Umwegleitung (5), in dem sich die wenigstens zwei Strahlumlenkeinrichtungen (6,7) befinden, zum Strahlteiler (4) zurückgeführt und anschließend ebenfalls der Beleuchtungsrefernzfläche (3) zugeführt wird.

2. System nach Anspruch 1, dadurch gekennzeichnet, daß die Aufteilung des Laserstrahls (2) in einem Teilungsverhältnis von erstem Teilstrahl (2a) zu zweitem Teilstrahl (2b) mit wenigstens annähernd 33.3/66.7 steht.

3. Vorrichtung zur wenigstens weitgehenden Kompensation von Richtungs- und Positionsänderungen eines von einem Laser erzeugten Lichtstrahles, insbesondere für eine mikrolithografische Beleuchtungseinrichtung, dadurch gekennzeichnet, daß zur Aufteilung des Laserstrahls (2) in Teilstrahlen (2a,2b) ein Strahlteiler (4) und wenigstens zwei Strahlumlenkeinrichtungen (6,7) zwischen dem Laser (1) und der Beleuchtungseinrichtung (Beleuchtungsreferenzfläche 3) angeordnet sind, wobei die Strahlumlenkeinrichtungen (6,7) derart angeordnet sind, daß sie den durch sie umgelenkten Teilstrahl (2b) zu dem Strahlteiler (4) zurückführen.

4. Vorrichtung nach Anspruch 3, dadurch gekennzeichnet, daß der Strahlteiler als Strahlteilerwürfel (4) ausgebildet ist.

5. Vorrichtung nach Anspruch 3 oder 4, dadurch gekennzeichnet, daß die Strahlumlenkeinrichtungen als Umlenkspiegel (6,7) ausgebildet sind.
